# EUROPEAN PATENT APPLICATION

(11) **EP 2 242 092 A1**
(43) Date of publication of application: **20.10.2010**
(21) Application number: 09705243.5
(22) Date of filing: 20.01.2009
(51) Int. Cl.: H01L 21/318, C23C 16/42, H01L 21/31, H01L 21/768, H01L 23/522, H05H 1/46

(54) **PLASMA PROCESSING METHOD AND PLASMA PROCESSING SYSTEM**

(30) Priority: 28.01.2008 JP 2008015894
(71) Applicant: Mitsubishi Heavy Industries, Ltd., Tokyo 108-8215 (JP)
(72) Inventor: SHIMAZU, Tadashi, Kobe-shi Hyogo 652-8585 (JP); NISHIKAWA, Seiji, Kobe-shi Hyogo 652-8585 (JP); KAFUKU, Hidetaka, Takasago-shi Hyogo 676-8686 (JP)
(74) Representative: Bongiovanni, Simone
(86) International application number: PCT/JP2009/050703
(87) International publication number: WO 2009/096259

(57) **Abstract**

In order to provide a plasma processing method and a plasma processing system which is capable of embedding a SiN film can be performed by applying bias power, in a plasma processing method for depositing a silicon nitride film on a substrate 21, which is a target for plasma processing, by using plasma of a raw material gas containing silicon and hydrogen and of a gas containing nitrogen, the bias power to inject ions into the substrate 21 is set equal to or higher than a threshold to increase a Si-H bonding amount, thereby reducing compression stress.

## Description

### TECHNICAL FIELD

The present invention relates to a plasma processing method and a plasma processing system.

### BACKGROUND ART

Needs for embedding a SiN film in a minute hole having a high aspect ratio (such as a hole having a hole diameter φ smaller than 1 µm and an aspect ratio of 1 or more) have been increasing recently along with miniaturization of semiconductor elements. Bias power needs to be increased to perform the embedding of a SiN film by use of a plasma CVD apparatus.

This is because, when little or no bias power is applied in the film deposition, a film is deposited more at an aperture than at a bottom of the hole due to an incidence angle of a precursor of the film to be deposited. As a result, the aperture of the hole is occluded, and a void is formed inside the hole. However, increasing the bias power causes film deposition and sputtering to be performed at the same time, suppressing the deposition at the aperture and thus allowing the progress of the film deposition at the bottom of and inside the hole. Accordingly, this enables the embedding of a film with no voids. Examples of such plasma processing are disclosed in Non-patent Document 1 and Non-patent Document 2 cited below.

Non-patent Document 1: Tatsuru Shirafuji, "Gas phase/surface reactions of plasma-enhanced CVD", [online], [searched on January 16, 2008], the Internet <URL: http://shira.iic.kyoto-u.ac.jp/2006-09-02-PECVD-Lecture.pdf >
Non-patent Document 2: C. W. Pearce, R. F. Fetcho, M. D. Gross, R. F. Koefer, R. A. Pudliner, "Characteristics of silicon nitride deposited by plasma-enhanced chemical vapor deposition using a dual frequency radio-frequency source" J. Appl. Phys. February 15, 1992, Vol. 71, No. 4, p. 1838-1841

### DISCLOSURE OF THE INVENTION

### PROBLEM TO BE SOLVED BY THE INVENTION

However, as disclosed in Fig. 31 of the above-mentioned Non-patent Document 1, in the conventional plasma processing method, the increasing of the bias power causes the (Si-H bonding amount) / (N-H bonding amount) of a SiN film to be reduced, and along therewith, the compression stress increases. Hence there is a problem that occurrence of a detached film attributable to this increase in the compression stress constitutes an obstacle for embedding of a SiN film by applying the bias power.

From this point of view, an object of the present invention is to provide a plasma processing method and a plasma processing system, which are capable of embedding a SiN film while suppressing an increase in compression stress and a decrease in Si-H/N-H bonding due to application of bias power.

### MEANS FOR SOLVING THE PROBLEM

A plasma processing method according to a first invention for solving the above problem is a plasma processing method for depositing a silicon nitride film on a substrate, which is a target for plasma processing, by using plasma of a raw material gas containing silicon and hydrogen and of a gas containing nitrogen, the plasma processing method characterized in that, bias power to inject ions into the substrate is set equal to or higher than a threshold to increase a Si-H bonding amount, thereby reducing compression stress.

A plasma processing method according to a second invention for solving the above problem is the plasma processing method according to the first invention characterized in that RF power to be applied to generate the plasma is reduced to increase the Si-H bonding amount, thereby reducing the compression stress

A plasma processing method according to a third invention for solving the above problem is the plasma processing method according to the first invention characterized in that pressure is raised to increase the Si-H bonding amount, thereby reducing the compression stress.

A plasma processing method according to a fourth invention for solving the above problem is the plasma processing method according to the first invention characterized in that amounts of supply of the gas containing nitrogen are increased to increase the Si-H bonding amount, thereby reducing the compression stress.

A plasma processing method according to a fifth invention for solving the above problem is the plasma processing method according to the first invention characterized in that a plasma processing temperature is lowered to increase the Si-H bonding amount, thereby reducing the compression stress.

A plasma processing method according to a sixth invention for solving the above problem is the plasma processing method according to the first invention characterized in that the threshold is set to 1.2 kW in a case of a 200-mm wafer.

A plasma processing system according to a seventh invention for solving the above problem is a plasma processing system characterized by comprising: gas supply amount controlling means for controlling gas supply amounts of a raw material gas containing silicon and hydrogen and a gas containing nitrogen to be supplied into a vacuum chamber; pressure controlling means for controlling pressure inside the vacuum chamber; plasma generating means for generating plasma by applying RF power to the raw material gas and the nitrogen gas inside the vacuum chamber; substrate holding means for holding a substrate, which is a target for plasma processing, inside the vacuum chamber; temperature controlling means for controlling a temperature during the plasma processing of the substrate; bias power applying means for applying bias power to the substrate; and parameter controlling means for setting the bias power to inject ions into the substrate equal to or higher than a threshold to increase a Si-H bonding amount, thereby reducing compression stress.

### EFFECTS OF THE INVENTION

According to the present invention, in a plasma processing method of depositing a silicon nitride film on a substrate, which is a target for plasma processing, by using plasma of a raw material gas containing silicon and hydrogen and a gas containing nitrogen, compression stress in the silicon nitride film can be reduced by increasing a Si-H bonding amount in the silicon nitride film. This suppresses film detachment attributable to an increase of the compression stress in the SiN film at the time of bias power application. Therefore, it is possible to embed a SiN film by applying the bias power.

### BRIEF DESCRIPTION OF THE DRAWINGS

[Fig. 1] Fig. 1 is a configuration diagram of a plasma processing system according to an embodiment of the present invention.
[Fig. 2] Fig. 2 is a view showing, in the form of a graph, an experiment result of an experiment to measure compression stresses in respective SiN films formed with variation in the bias power to be applied.
[Fig. 3] Fig. 3 is a view showing, in the form of a graph, an experiment result of an experiment to measure Si-H amount/N-H amount in respective SiN films formed with variation in the bias power to be applied.
[Fig. 4] Fig. 4 is a view showing a micrograph of the SiN film deposited with a bias power set to 0.5 kW.
[Fig. 5] Fig. 5 is a view showing a micrograph of the SiN film deposited with a bias power set to 1.6 kW.
[Fig. 6] Fig. 6 is a view showing a micrograph of the SiN film deposited with a bias power set to 2.4 kW.
[Fig. 7] Fig. 7 is a view showing, in the form of a graph, an experiment result of an experiment to measure compression stresses in respective SiN films having a different film thicknesses.
[Fig. 8] Fig. 8 is a view showing, in the form of a graph, an experiment result of an experiment to measure compression stresses in respective SiN films deposited with variation in film deposition rate.

### BEST MODE FOR CARRYING OUT THE INVENTION

An embodiment of a plasma processing method and a plasma processing system according to the present invention will be described below by using the drawings.

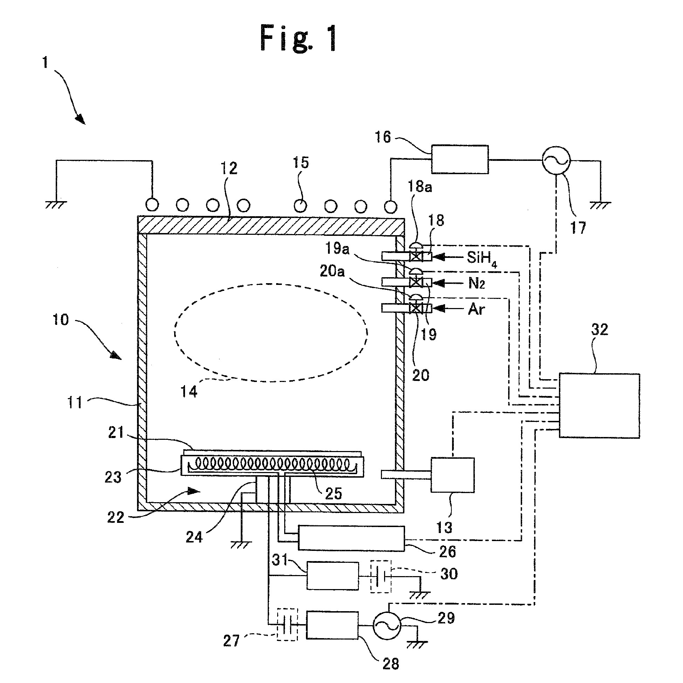

Fig. 1 is a configuration diagram of the plasma processing system according to the embodiment of the present invention. As shown in Fig. 1, the plasma processing system 1 includes a vacuum chamber 10 capable of maintaining a high degree of vacuum. This vacuum chamber 10 includes a cylindrical container 11 and a ceiling plate 12 and forms a space which is hermetically sealed from outside air by fitting the ceiling plate 12 onto an upper portion of the cylindrical container 11.

The vacuum chamber 10 is provided with a vacuum device 13 to establish a vacuum state inside the vacuum chamber 10. A RF antenna 15 configured to generate plasma 14 is located at an upper portion of the ceiling plate 12. A RF power source 17 being a high-frequency power source is connected to this RF antenna 15 via a rectifier 16. Specifically, RF power supplied from the RF power source 17 is supplied to the plasma 14 through the RF antenna 15.

A raw material gas supply tube 18 configured to supply raw material gas being a material of a film to be deposited into the vacuum chamber 10 is disposed at an upper portion of a side wall of the cylindrical container 11. The raw material gas supply tube 18 is provided with a raw material gas supply amount control valve 18a configured to control a supply amount of the raw material gas. In this embodiment, SiH₄ is supplied as the raw material gas. A N₂ gas supply tube 19 configured to supply N₂ gas into the vacuum chamber 10 is disposed at the upper portion of the side wall of the cylindrical container 11. The N₂ gas supply tube 19 is provided with a N₂ gas supply amount control valve 19a configured to control a supply amount of the N₂ gas. An Ar supply tube 20 configured to supply Ar gas into the vacuum chamber 10 is disposed at the upper portion of the side wall of the cylindrical container 11. The Ar gas supply tube 20 is provided with an Ar gas supply amount control valve 20a configured to control a supply amount of the Ar gas. By these constituents, the plasma 14 of SiH₄, N₂, and Ar is generated in an upper portion inside the vacuum chamber 10.

A substrate support table 22 configured to hold a substrate 21 being a target for film deposition is disposed in a lower portion inside the cylindrical container 11. This substrate support table 22 includes a substrate holding portion 23 configured to hold the substrate 21 and a support shaft 24 configured to support this substrate holding portion 23. A heater 25 for heating is disposed inside the substrate holding portion 23. A heater control device 26 adjusts the temperature of this heater 25. Accordingly, it is possible to control the temperature of the substrate 21 during the plasma processing.

A bias power source 29 is connected to the substrate holding portion 23 via a capacitor 27 and a rectifier 28 so that bias power can be applied to the substrate 21. This makes it possible to draw ions from the plasma 14 to a surface of the substrate 21. Further, an electrostatic power source 30 is connected to the substrate holding portion 23 so that the substrate 21 can be held by an electrostatic force. The electrostatic power source 30 is connected to the substrate holding portion 22 via a low-pass filter 31 (LPF) so that power from the RF power source 17 and the bias power source 29 does not flow into the electrostatic power source 30.

Additionally, a parameter control device 32 is provided which is capable of controlling the bias power of the bias power source 29, the RF power of the RF power source 17, pressure of the vacuum device 13, the heater control device 26, and the gas supply amounts of the raw material gas supply valve 18a, the N₂ gas supply valve 19a, and the Ar gas supply valve 20a, respectively. Note that dashed lines in Fig. 1 represent signal lines for transmitting control signals from the parameter control device to the bias power source 29, the RF power source 17, the vacuum device 13, the heater control device 26, the raw material gas supply valve 18a, the N₂ gas supply valve 19a, and the Ar gas supply valve 20a.

In the above-described plasma processing system according to this embodiment, embedding of a film by applying the bias power is made possible by use of the parameter control device 32 which controls the bias power, the RF power, the pressure, a film deposition temperature, and the gas supply amounts on the basis of conditions to be described later. The parameter control device 32 according to this embodiment particularly sets the bias power for injecting ions into the substrate 21 equal to or higher than a threshold to increase a Si-H bonding amount, thereby performing control to reduce compression stress. Here, the reason why it is possible to reduce the compression stress by setting the bias power for injecting ions into the substrate 21 equal to or higher than the threshold to increase the Si-H bonding amount will be described below in detail.

Now, experiment results of various experiments carried out by using the plasma processing system according to this embodiment will be described to begin with.
An experiment was performed as a first experiment in which compression stresses, a Si-H bonding amounts, and a N-H bonding amounts in respective SiN films were measured, the SiN films each applied with different bias power while being formed. Here, the substrate 21 (see Fig. 1) as the target for film deposition processing is assumed to be a wafer having a diameter of 200 mm. As for process conditions at the time of deposition of each of the SiN films, the RF power (13.56 MHz) was set to 2 kW, flow rates of SiH₄, N₂, and Ar were all set to 50 sccm, the pressure was set to 25 mTorr, the film deposition temperature was set to 250°C, and a film thickness of the SiN film to be deposited was set to 350 nm.

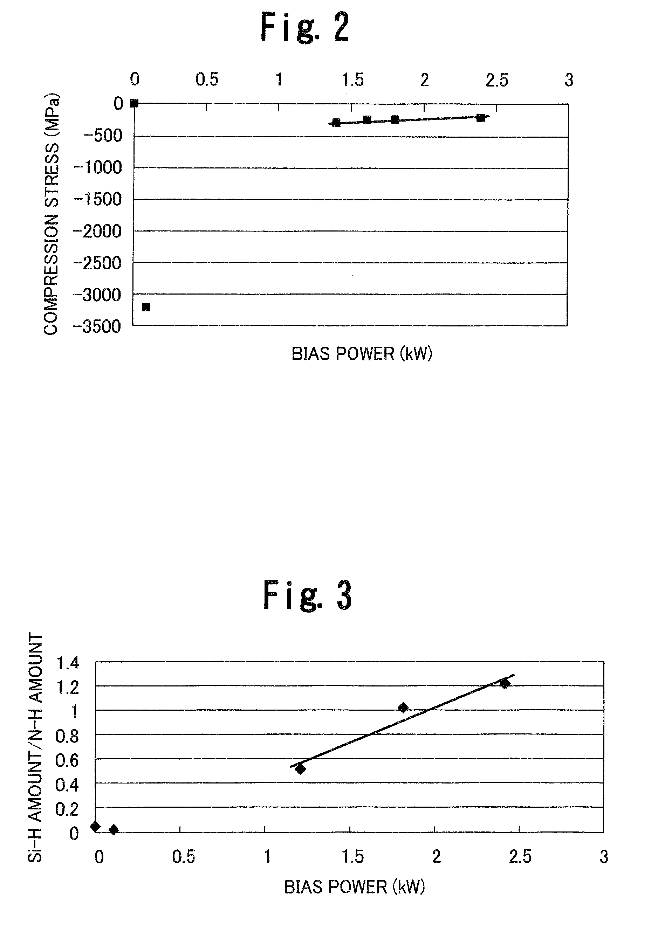

Shown are results of measurement of compression stresses in the respective SiN films formed under the above-described process conditions with variation in the bias power (4 MHz) to be applied. Table 1 is a table showing the experiment result of the experiment to measure the compression stresses in the respective SiN films formed with variation in the bias power to be applied. Fig. 2 is a view showing, in the form of a graph, the experiment result shown in Table 1.

**[Table 1]**

| | | | | | | |
|---|---|---|---|---|---|---|
| Bias power [kW] | 0 | 0.1 | 1.4 | 1.6 | 1.8 | 2.4 |
| Compression Stress [Mpa] | -44 | -3251 | -307 | -274 | -259 | -225 |

As shown in Fig. 2, the compression stress is increased by application of the bias power as similar to the conventional case up to the bias power of 0.1 kW (0.1 kW is maximal). However, the compression stress becomes smaller when the bias power is increased further. Moreover, the state of the SiN film was observed in each bias power levels, and it was found out that film detachment occurred at bias power level of 1. 6 kW or lower, but film detachment did not occur at bias power level of 1.8 kW or higher. Accordingly, it is apparent that the bias power needs to be set equal to or higher than a predetermined threshold in order to suppress occurrence of film detachment. For this reason, it is necessary to apply the bias power of 5.7 W/cm² per unit area (1.8 kW in the case of the 200-mm wafer) or higher to the substrate 21 (see Fig. 1) in order to set the bias power equal to or higher than the threshold.

Shown is a result of measurement of the Si-H bonding amounts and the N-H bonding amounts of the SiN films formed under the above-described process conditions with variation in the bias power (4 MHz) to be applied, the measurement performed by using a FTIR (Fourier transform infrared spectrophotometer). Table 2 is a table showing the experiment result of the experiment to measure the Si-H bonding amounts and the N-H bonding amounts in the SiN films formed with variation in the bias power to be applied. Meanwhile, Fig. 3 is a view showing, in the form of a graph, the measurement result of the Si-H amounts/N-H amounts in the SiN films formed with variation in the bias power to be applied, which are shown Table 2.

**[Table 2]**

| | | | | | |
|---|---|---|---|---|---|
| Bias power [kW] | 0 | 0.1 | 1.2 | 1.8 | 2.4 |
| Si-H bonding amount | 0.9 | 0.78 | 5.7 | 12.2 | 15.8 |
| [*10²¹/cm³] | | | | | |
| N-H bonding amount | 19.5 | 31 | 11.0 | 12.0 | 12.9 |
| [*10²¹/cm³] | | | | | |
| Si-H/N-H | 0.05 | 0.025 | 0.52 | 1.0 | 1.2 |

As shown in Fig. 3, the Si-H/N-H is decreased as similar to the conventional case up to the bias power of 0.1 kW. However, when the bias power is increased further, the Si-H bonding amount is increased in proportion to the bias power and the Si-H amount/N-H amount are increased.

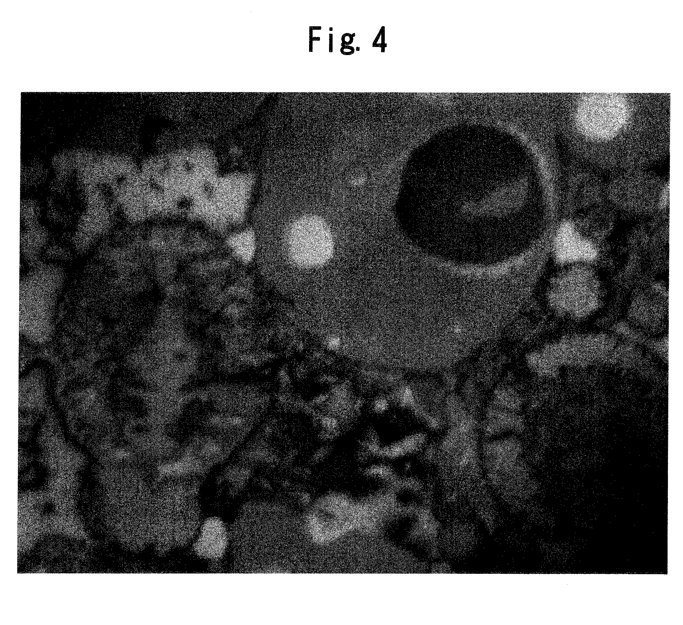

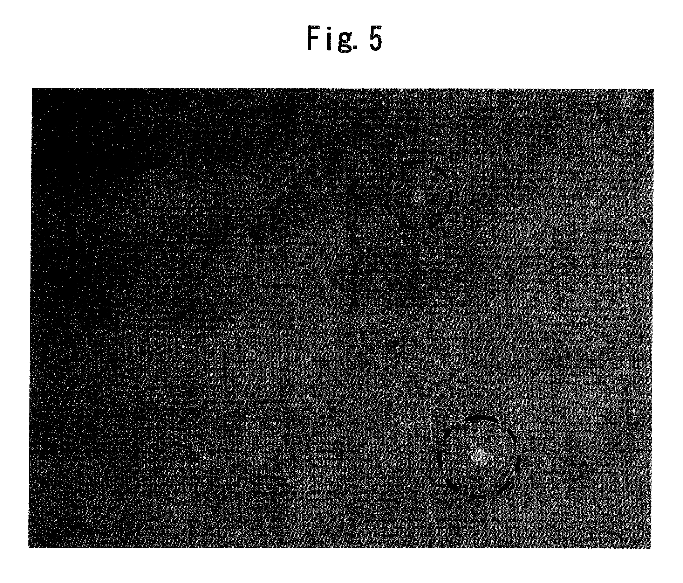

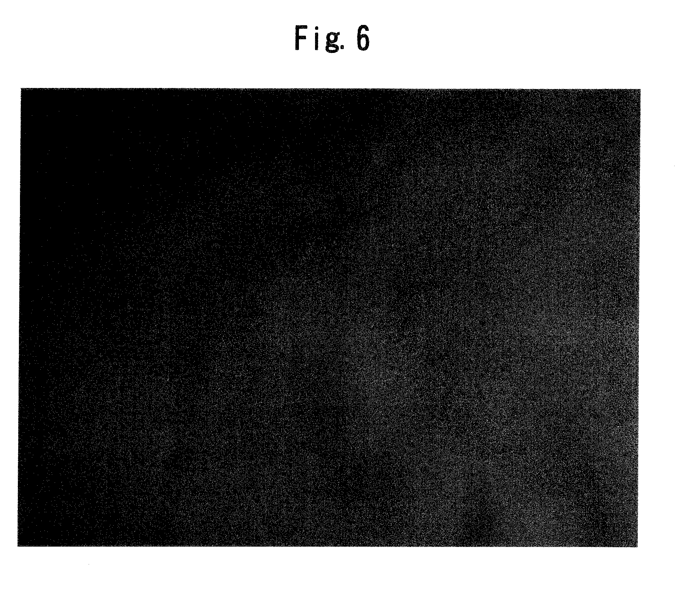

The state of each of the deposited SiN films in the case where the bias power is set to 0.5kW, 1.6 kW, or 2.4 kW during the deposition of the SiN film will be described. Fig. 4 is a view showing a micrograph of the SiN film deposited with a bias power set to 0.5 kW, Fig. 5 is a view showing a micrograph of the SiN film deposited with a bias power set to 1.6 kW, and Fig. 6 is a view showing the micrograph of a SiN film deposited with a bias power set to 2.4 kW.

As shown in Fig. 4, when the bias power is set to 0.5 kW, film detachment occurs across a front surface of the substrate 21 (see Fig. 1). Note that portions which seem like patterns in Fig. 4 represent portions where the film is detached. Meanwhile, as shown in Fig. 5, when the bias power is set to 1.6 kW, there is minor film detachment. Note that portions which seem like small dots as surrounded by broken lines in Fig. 5 represent portions where the film is detached.

Meanwhile, as shown in Fig. 6, when the bias power is set to 2.4 kW, film detachment does not occur. Accordingly, the film detachment occurs when the bias power is lower than about 1.6 kW, but does not occur when the bias power is about 2.4 kW.

From the result of the first experiment, the compression stress in the SiN film is reduced and the Si-H amount/N-H amount increases when the bias power is set higher than the threshold. This is presumably because the bias power (ion impact) lower than the threshold causes enhancement in film density and increase in the compression stress, while the compression stress is reduced due to a drawing effect of hydrogen which occurs when the bias power higher than the threshold is applied. In other words, the conventional technique has the problem of film detachment due to the increase in the compression stress which occurs when the bias power is increased to embed a SiN film. Meanwhile, in the present invention, it has been found out that, by controlling the bias power to be equal to or higher than the threshold, the compression stress is reduced due to the drawing effect of hydrogen. This allows the embedding of a film.

An experiment was performed as a second experiment in which the compression stresses were measured in respective cases where the film thicknesses of the SiN film to be deposited were 350 nm and 10000 nm, respectively, at the time of deposition of the SiN films. Here, the substrate 21 (see Fig. 1) as the target for film deposition processing is assumed to be a wafer having the diameter of 200 mm. As for process conditions at the time of deposition of each of the SiN films, the bias power (4 MHz) was set to 2.4 kW, the RF power (13.56 MHz) is set to 2 kW, the flow rates of SiH₄, N₂, and Ar were all set to 50 sccm, the pressure was set to 25 mTorr, and the film deposition temperature is set to 250°C.

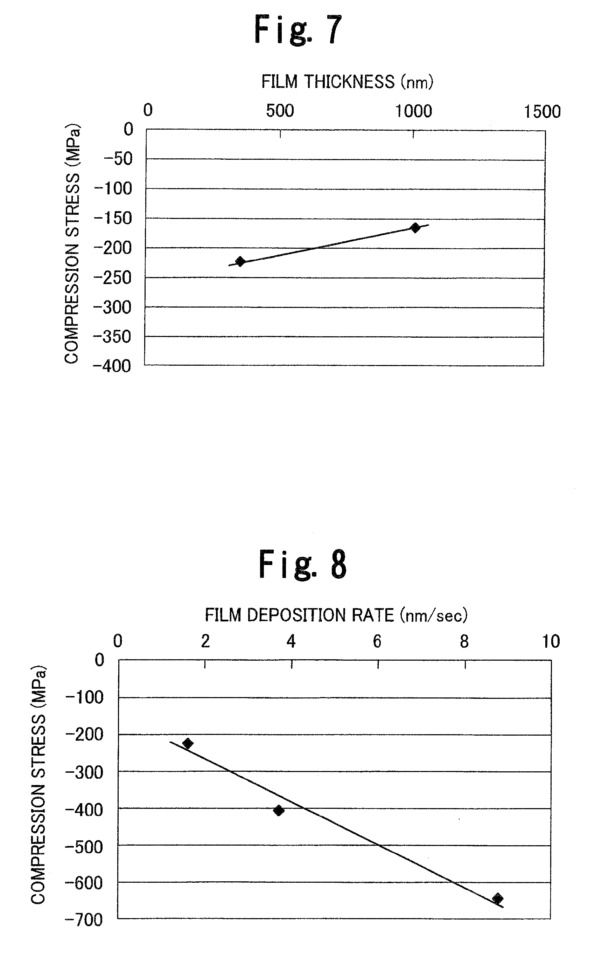

Table 3 is a table showing an experiment result of the experiment to measure the compression stresses of the respective SiN films having the film thicknesses of 350 nm and 10000 nm, respectively. Meanwhile, Fig. 7 is a view showing, in the form of a graph, the experiment result of the compression stresses in the respective SiN films having different film thicknesses of the SiN film between 350 nm and 10000 nm, respectively, as shown in Table 3.

**[Table 3]**

| | | |
|---|---|---|
| Film thickness [nm] | 350 | 10000 |
| Compression stress [MPa] | -225 | -164 |

As shown in Fig. 7, the compression stress in the SiN film becomes smaller when the film thickness of the SiN film is increased. This is because the Si-H bonding amount of the entire SiN film increases when the film thickness becomes thicker. Accordingly, the Si-H bonding amount can be controlled by controlling the film thickness, thereby allowing the control of the compression stress in the SiN film. Here, it turns out from the result of the second experiment that the embedding of the film is possible even in a hole having a depth of 1 µm or more.

An experiment was performed as a third experiment in which the compression stresses in the respective SiN films were measured, the SiN films deposited with variation in film deposition rate by changing the flow rate of SiH₄ at the time of deposition of the SiN film. Here, the substrate 21 (see Fig. 1) as the target for film deposition processing is assumed to be a wafer having the diameter of 200 mm. As for process conditions at the time of deposition of each of the SiN films, the bias power (4 MHz) was set to 2.4 kW, the RF power (13.56 MHz) was set to 2 kW, the flow rates of N₂ and Ar were both set to 50 sccm, the pressure is set to 25 mTorr, the film deposition temperature was set to 250°C, and the film thickness of the SiN film to be deposited was set to 350 nm.

Table 4 is a table showing an experiment result of the experiment to measure the compression stresses in the respective SiN films deposited with variation in film deposition rate. Meanwhile, Fig. 8 is a view showing, in the form of a graph, the experiment result of the compression stresses in the respective SiN films deposited with variation in film deposition rate as shown in Table 4.

**[Table 4]**

| | | | |
|---|---|---|---|
| SiH₄ flow rate [sccm] | 50 | 80 | 150 |
| Film deposition rate [nm/sec] | 1.6 | 3.7 | 8.8 |
| Compression stress [MPa] | -225 | -408 | -642 |

As shown in Fig. 8, the compression stress in the SiN film becomes larger when the film deposition rate becomes larger. Accordingly, by setting the film deposition rate smaller, it is possible to suppress occurrence of film detachment even when the bias power to be applied is set lower than the above-described threshold of the bias power.

An experiment was performed as a fourth experiment in which the Si-H bonding amounts in the respective SiN films were measured, the SiN films deposited with variation in film deposition temperature. Here, the substrate 21 (see Fig. 1) as the target for film deposition processing is assumed to be a wafer having the diameter of 200 mm. As for process conditions at the time of deposition of each of the SiN films, the bias power (4 MHz) was set to 2.4 kW, the RF power (13.56 MHz) was set to 2 kW, the flow rates of SiH₄, N₂, and Ar were all set to 50 sccm, the pressure was set to 25 mTorr, and the film thickness of the SiN film to be deposited was set to 350 nm.

Table 5 is a table showing an experiment result of the experiment to measure the Si-H bonding amounts in the respective SiN films deposited with variation in film deposition temperature.

**[Table 5]**

| | | |
|---|---|---|
| Film deposition | 250 | 430 |
| temperature [C°] | | |
| Si-H bonding amount | 15.8 | 7.5 |
| [*10²¹/cm³] | | |
| N-H bonding amount | 12.9 | 10.1 |
| [*10²¹/cm³] | | |
| Si-H/N-H | 1.2 | 0.74 |

As shown in Table 5, the Si-H bonding amount is increased when the film deposition temperature becomes lower. Accordingly, the Si-H bonding amount can be controlled by controlling the film deposition temperature, thereby allowing the control of the compression stress in the SiN film. In other words, the Si-H bonding amount can be increased by lowering the film deposition temperature, thereby allowing reduction of the compression stress in the SiN.

An experiment was performed as a fifth experiment in which the Si-H bonding amounts in the respective SiN films were measured, the SiN films deposited with variation in flow rate of SiH₄ relative to the flow rate of N₂ (the SiH₄ flow rate/N₂ flow rate) . Here, the substrate 21 (see Fig. 1) as the target for film deposition processing is assumed to be a wafer having the diameter of 200 mm. As for process conditions at the time of deposition of each of the SiN films, the bias power (4 MHz) was set to 2.4 kW, the RF power (13.56 MHz) was set to 2 kW, the flow rate of Ar was set to 50 sccm, the pressure was set to 25 mTorr, the film deposition temperature was set to 250°C, and the film thickness of the SiN film to be deposited was set to 350 nm.

Table 6 is a table showing an experiment result of the experiment to measure the Si-H bonding amounts in the respective SiN films deposited with variation in SiH₄ flow rate/N₂ flow rate.

**[Table 6]**

| | | |
|---|---|---|
| SiH₄ flow rate/N₂ flow rate | 0.5 | 1.0 |
| Si-H bonding amount [*10²¹/cm³] | 5.1 | 15.8 |
| N-H bonding amount [*10²¹/cm³] | 17.1 | 12.9 |
| Si-H/N-H | 0.3 | 1.2 |

As shown in Table 6, the Si-H bonding amount is increased when the SiH₄ flow rate/N₂ flow rate becomes larger. Accordingly, the Si-H bonding amount can be controlled by controlling the SiH₄ flow rate/N₂ flow rate, thereby allowing the control of the compression stress in the SiN film. In other words, the Si-H bonding amount can be increased by increasing the SiH₄ flow rate/N₂ flow rate, thereby allowing the reduction of the compression stress in the SiN.

An experiment was performed as a sixth experiment in which the Si-H bonding amounts in SiN films deposited with variation in RF power to be applied. Here, the substrate 21 (see Fig. 1) as the target for film deposition processing is assumed to be a wafer having the diameter of 200 mm. As for process conditions at the time of deposition of each of the SiN films, the bias power (4 MHz) was set to 2.4 kW, the flow rates of SiH₄, N₂, and Ar were all set to 50 sccm, the pressure was set to 25 mTorr, the film deposition temperature was set to 250°C, and the film thickness of the SiN film to be deposited was set to 350 nm.

Table 7 is a table showing an experiment result of the experiment to measure the Si-H bonding amounts in the respective SiN films deposited with variation in RF power to be applied.

**[Table 7]**

| | | |
|---|---|---|
| RF power [kW] | 3.0 | 4.0 |
| Si-H bonding amount [*10²¹/cm³] | 17.1 | 13.9 |
| N-H bonding amount [*10²¹/cm³] | 6.7 | 11.4 |
| Si-H/N-H | 2.6 | 1.2 |

As shown in Table 7, the Si-H bonding amount is increased when the RF power becomes smaller. Accordingly, the Si-H bonding amount can be controlled by controlling the RF power, thereby allowing the control of the compression stress in the SiN film. In other words, the Si-H bonding amount can be increased by decreasing the RF power, thereby allowing the reduction of the compression stress in the SiN.

An experiment was performed as a seventh experiment in which the Si-H bonding amounts in SiN films were measured, the SiN films deposited with variation in pressure to be applied. Here, the substrate 21 (see Fig. 1) as the target for film deposition processing is assumed to be a wafer having the diameter of 200 mm. As for process conditions at the time of deposition of each of the SiN films, the bias power (4 MHz) was set to 2.4 kW, the RF power (13.56 MHz) was set to 2 kW, the flow rates of SiH₄, N₂, and Ar were all set to 50 sccm, the film deposition temperature was set to 250°C, and the film thickness of the SiN film to be deposited was set to 350 nm.

Table 8 is a table showing an experiment result of the experiment to measure the Si-H bonding amounts in the respective SiN films deposited with variation in pressure to be applied.

**[Table 8]**

| | | |
|---|---|---|
| Pressure [Pa] | 1.3 | 3.3 |
| Si-H bonding amount [*10²¹/cm³] | 8.9 | 15.8 |
| N-H bonding amount [*10²¹/cm³] | 11.1 | 12.9 |
| Si-H/N-H | 0.8 | 1.2 |

As shown in Table 8, the Si-H bonding amount is increased when the pressure becomes higher. Accordingly, the Si-H bonding amount can be controlled by controlling the pressure, thereby allowing the control of the compression stress in the SiN film. In other words, the Si-H bonding amount can be increased by raising the pressure, thereby allowing the reduction of the compression stress in the SiN.

As described above, from the results of the first to seventh experiments, it is found out that there is a negative correlation between the amount of Si-H groups (the Si-H bonding amount) in the SiN film and the compression stress in the SiN film in an area applied with the bias power equal to or higher than the threshold. Accordingly, the Si-H bonding amount in the SiN film can be increased by causing the parameter control device 32 (see Fig. 1) to control the bias power, the RF power, the pressure, the film thickness, the gas mixture ratio, and the film deposition temperature, thereby reducing the compression stress in the SiN film. This allows embedding of the SiN film by applying the bias power.

To be more precise, assume that the process conditions at the time of deposition of the SiN film are set as follows. The RF power (13.56 MHz) is 2 kW, the flow rates of the SiH₄, N₂, and Ar are 50 sccm, the pressure is 25 mTorr, the film deposition temperature is 250°C, and the film thickness of the SiN film to be deposited is 350 nm. Here, the parameter control device 32 performs a control so that the bias power of 5.7 W/cm² per unit area or higher (in the case of the 200-mm wafer, the radius r of the wafer = 10 cm and the area of the wafer is πr²= 3.14 × 10² cm²= 314 cm²; therefore, the bias power to be applied to the wafer is 314 cm² × 5.7 W/cm² = 1.79 kW, and this value is rounded to the nearest tenth above to 1.8 kW) is applied to the substrate 21 (see Fig. 1) as the target for film deposition. Moreover, when the bias power of 5.7 W/cm² per unit area or lower is applied to the substrate 21 (see Fig. 1) as the target for film deposition, the control is performed so that the RF power becomes smaller, the pressure becomes higher, the SiH₄ flow rate/N₂ flow rate becomes larger, and the film deposition temperature becomes lower.

This SiN film embedded by applying the bias power can be applied to, for example, an image sensor (CCD/CMOS) lens and a waveguide utilizing a high refractive index and high permeability of the SiN film, a final protective film for wiring utilizing a barrier property of the SiN film. In particular, since it is possible to increase the Si-H bonding amount in the film by controlling the bias power, the RF power, the pressure, the film thickness, the gas mixture ratio, and the film deposition temperature, an application to the image sensor is effective whose dark current is known to be reduced by terminating dangling-bond of Si atom with hydrogen.

### INDUSTRIAL APPLICABILITY

The present invention is applicable to a plasma processing method capable of embedding SiN film while applying bias power and to a plasma processing system.

## Claims

1. A plasma processing method for depositing a silicon nitride film on a substrate, which is a target for plasma processing, by using plasma of a raw material gas containing silicon and hydrogen and of a gas containing nitrogen, the plasma processing method **characterized in that**,
bias power to inject ions into the substrate is set equal to or higher than a threshold to increase a Si-H bonding amount, thereby reducing compression stress.

2. The plasma processing method according to claim 1, **characterized in that** RF power to be applied to generate the plasma is reduced to increase the Si-H bonding amount, thereby reducing the compression stress.

3. The plasma processing method according to claim 1, **characterized in that** pressure is raised to increase the Si-H bonding amount, thereby reducing the compression stress.

4. The plasma processing method according to claim 1, **characterized in that** amounts of supply of the raw material gas and the gas containing nitrogen are increased to increase the Si-H bonding amount, thereby reducing the compression stress.

5. The plasma processing method according to claim 1, **characterized in that** a plasma processing temperature is lowered to increase the Si-H bonding amount, thereby reducing the compression stress.

6. The plasma processing method according to claim 1, **characterized in that** the threshold is set to 1.2 kW in a case of a 200-mm wafer.

7. A plasma processing system **characterized by** comprising:
gas supply amount controlling means for controlling gas supply amounts of a raw material gas containing silicon and hydrogen and a gas containing nitrogen to be supplied into a vacuum chamber;
pressure controlling means for controlling pressure inside the vacuum chamber;
plasma generating means for generating plasma by applying RF power to the raw material gas and the nitrogen gas inside the vacuum chamber;
substrate holding means for holding a substrate, which is a target for plasma processing, inside the vacuum chamber;
temperature controlling means for controlling a temperature during the plasma processing of the substrate;
bias power applying means for applying bias power to the substrate; and
parameter controlling means for setting the bias power to inject ions into the substrate equal to or higher than a threshold to increase a Si-H bonding amount, thereby reducing compression stress.
